# FASCICULE DE BREVET EUROPEEN

(11) **EP 2 253 963 B1**
(45) Date de publication et mention de la délivrance du brevet: **08.02.2012**
(21) Numéro de dépôt: 10354012.6
(22) Date de dépôt: 19.03.2010
(51) Int. Cl.: G01R 15/14, H01R 13/24, H02B 13/00, H01R 13/648

(54) **Capteur d'une grandeur électrique à interface plane et connexion adapt**
Sensor für eine elekrische Grösse mit flacher Kopplung und angepasstem Anschluss
Sensor for an electric variable having a flat interface and adapted connector

(30) Priorité: 18.05.2009 FR 0902432
(43) Date de publication de la demande: 24.11.2010
(73) Titulaire: Schneider Electric Industries SAS, 92500 Rueil-Malmaison (FR)
(72) Inventeur: Bonfils, Jean-Michel, 38050 Grenoble Cedex 09 (FR)
(74) Mandataire: Péru, Laurence

(56) Documents cités:
- EP-A1- 0 674 375
- EP-A1- 1 345 033
- WO-A2-2004/034535
- DE-A1- 4 435 864
- FR-A- 1 055 042
- US-A1- 2002 008 084
- US-A1- 2006 051 981
- US-A1- 2007 227 757

## Description

### DOMAINE TECHNIQUE

L'invention concerne la simplification de la mesure d'une information relative à une connexion électrique, par exemple le courant ou la tension, grâce à des interfaces de raccordement permettant une liaison électrique par contact entre surfaces planes. Le capteur réalisé pour un tel dispositif de mesure comprend des surfaces de raccordement et une géométrie interne dont la forme et le matériau sont choisis pour garantir la tenue diélectrique, en particulier pour des applications à haute et/ou moyenne tension ; notamment, les surfaces sont partiellement déformables, et l'isolant des capteurs est surmoulé sur le coeur conducteur.

Un capteur et le dispositif de mesure associé selon l'invention peuvent être utilisés avec des barres de connexion blindées adaptées ou d'autres types de raccordement, eux aussi optimisés.

### ETAT DE LA TECHNIQUE

Dans les équipements électriques, en particulier dans les postes de transformation moyenne tension MT (aussi parfois appelés haute tension HT), c'est-à-dire de l'ordre de 1 à 52 kV, différents appareillages de distribution doivent être reliés électriquement entre eux ; qui plus est, au vu des tensions élevées et pour les protéger, il est avantageux d'isoler les liaisons par un surmoulage, et éventuellement de les blinder afin de diriger le champ électrique.

Différentes solutions ont été développées, avec notamment la mise en place de barres rigides reliées aux appareillages ; des connecteurs de type bicônes sont alors insérés. Une solution alternative permettant un encombrement réduit, notamment en hauteur, est présentée dans le document FR 2 923 953, demande de brevet publiée le 22 mai 09 et citée uniquement à titre indicatif au titre de l'article 54(3) CBE, avec des interfaces planes ; cette solution permet en outre de faciliter les procédés de raccordement. Ce type de raccordement simplifié peut être décliné. Dans certaines applications, des informations relatives au circuit électrique formé par les raccordements doivent être mesurées. En particulier, les dispositifs de mesure d'informations relatives au courant circulant entre les appareillages décrits par exemple dans le document DE 4435864 peuvent également bénéficier de la simplification offerte par un raccordement à interface plane de leur capteur.

### EXPOSE DE L'INVENTION

Parmi autres avantages, l'invention vise à simplifier le raccordement d'un dispositif de mesure d'une grandeur électrique avec un élément d'une ligne électrique, de type barre de connexion, câble ou borne, dont l'interface de raccordement est plane et compressible.

En particulier, l'invention concerne un dispositif de mesure de la tension et/ou du courant circulant dans la ligne au moyen d'un capteur inséré dans la ligne et des moyens de traitement adaptés, le capteur comprenant des interfaces de raccordement planes et compressibles.

Plus généralement, l'invention est également relative au capteur précédent. Notamment, le capteur selon l'invention comprend un support en matériau isolant susceptible d'être déformé et délimité par deux surfaces de raccordement opposées sensiblement parallèles, avantageusement circulaires superposables, et un insert de connexion conducteur intégré dans le support isolant duquel il débouche au niveau de deux surfaces de connexion planes parallèles, avantageusement circulaires superposables ; l'insert est percé d'un orifice traversant de serrage entre ses surfaces de connexion. Avantageusement, le support isolant est un élastomère de type EPDM surmoulé sur l'insert, avec par exemple formation d'un col au niveau des surfaces de connexion de façon à noyer l'insert dans le support.

La hauteur de l'insert entre ses deux surfaces de connexion est inférieure à la distance entre les deux surfaces de raccordement lorsque le matériau isolant du support est au repos, et supérieure ou égale à ladite distance lorsque le matériau est entièrement déformé par compression entre ses surfaces de raccordement, notamment lors du raccordement à une autre interface du même type, par exemple par serrage au moyen d'une tige traversant l'insert.

Pour permettre la mesure, le capteur comprend, au moins sur une partie centrale externe du support éloignée des surfaces de raccordement, un revêtement conducteur associé à des moyens d'obtention de la grandeur physique. Par exemple, les moyens d'obtention comprennent un bobinage secondaire enroulé autour d'un noyau qui peut être enrobé dans le revêtement ou rapporté, ou une résistance de mesure enrobée dans le support isolant associée à un conducteur débouchant du revêtement conducteur. De préférence, pour une mesure capacitive de la tension notamment, le revêtement conducteur est réalisé sur la surface externe du support à l'exception des surfaces de raccordement, et de deux épargnes périphériques qui délimitent trois parties, deux parties d'extrémité du revêtement servant de blindage et une partie centrale d'obtention des données ; avantageusement, l'épargne est comblée par un matériau isolant, par exemple une excroissance du support isolant.

Les interfaces entre le support isolant, l'insert conducteur et le revêtement conducteur du capteur selon l'invention sont étanches, tout comme les interfaces éventuels des moyens d'obtention placés dans le support isolant et/ou le revêtement. De préférence, le revêtement conducteur et le support isolant sont réalisés par surmoulage du même élastomère, chargé ou non de particules conductrices.

### BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.
La figure 1 montre une barre à interface plane ainsi que la connexion entre deux barres au niveau d'un de leurs dispositifs de raccordements, auxquelles un dispositif de mesure selon l'invention peut être associé.
La figure 2 représente un assemblage d'un capteur selon l'invention avec une barre selon la figure 1.
La figure 3 montre un dispositif de mesure selon un mode de réalisation de l'invention.
La figure 4 représente un assemblage alternatif d'un dispositif de mesure selon l'invention.

### DESCRIPTION DETAILLEE D'UN MODE DE REALISATION PREFERE

Dans certaines applications, certaines informations relatives au circuit électrique formé par une barre ou un jeu de barre permettant de relier entre elles les bornes de connexion de plusieurs appareils électriques doivent être mesurées. Classiquement, un dispositif de mesure comprend alors un capteur associé à un circuit de traitement de l'information obtenue par ledit capteur qui se met en place de façon appropriée au niveau d'un des éléments du raccordement électrique, ou plus généralement de la ligne de distribution.

Pour un mode de réalisation préféré, un capteur 100 selon l'invention est assemblé sur une connectique de configuration plane tel que décrite dans le FR 2923953.

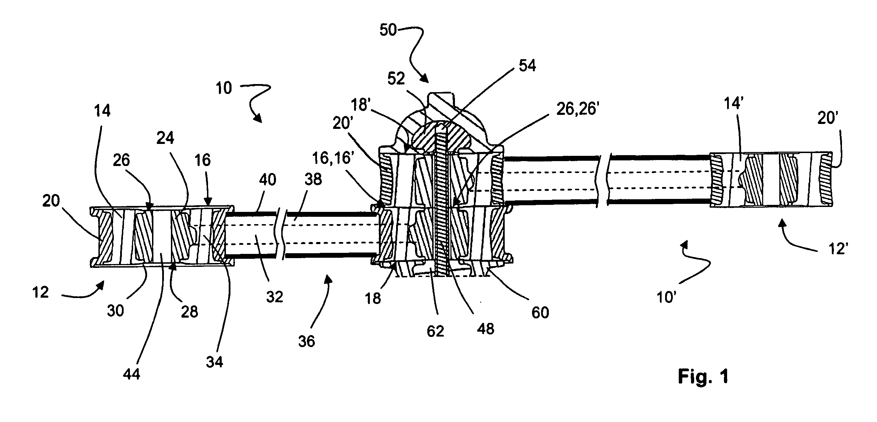

En particulier, tel qu'illustré en figure 1, une barre 10 est munie à chacune de ses extrémités au moins d'un dispositif de raccordement 12 qui comprend principalement un support 14 en matériau isolant. Bien qu'il puisse être de forme quelconque, le support isolant 14 comprend deux surfaces opposées 16, 18, destinées au raccordement, qui sont sensiblement planes et parallèles l'une à l'autre ; il est préféré que les surfaces de raccordement 16, 18 soient circulaires, forme la plus adaptée pour gérer les différents phénomènes diélectriques et optimiser l'orientation des empilements. De même, il est avantageux que les deux surfaces opposées 16, 18 d'un support isolant 14 soient superposables de sorte que la barre 10 peut être utilisée sans orientation préférée ; il est de toute façon préféré que la barre 10 soit symétrique, avec tous ses dispositifs de raccordement 12 identiques, leurs surfaces de raccordement 16, 18 étant parallèles entre elles.

Le support isolant 14, à l'exception des surfaces de raccordement 16, 18, est avantageusement revêtu d'une couche 20 conductrice ou semi-conductrice sur sa surface externe. L'épaisseur est déterminée en fonction de sa résistivité de façon à obtenir un revêtement 20 suffisant pour assurer un blindage électrostatique de l'ensemble : le maintien du champ électrique à l'intérieur du support isolant 14 permet d'augmenter la compacité des raccordements effectués par une barre 10 munie d'un tel dispositif 12 ; il peut être souhaitable de procéder à un retour de blindage sur la périphérie de la surface isolante de raccordement 16, 18, afin d'assurer une continuité de blindage lors du contact avec une autre surface similaire 16'.

Le dispositif de raccordement 12 comprend en outre un insert de connexion 24 de forte conductivité électrique, usuellement en cuivre ou en aluminium, qui traverse le dispositif de raccordement 12 dans son épaisseur, entre deux surfaces de connexion 26, 28 planes et parallèles qui sont accessibles de chaque côté du support isolant 14. Avantageusement, l'insert de connexion 24 est centré au sein du support isolant 14, et symétrique de révolution afin de maîtriser au mieux les contraintes diélectriques.

Pour optimiser la tenue diélectrique, l'insert de connexion 24 est intégré au support isolant 14, et notamment le matériau isolant est surmoulé sur l'insert 24 de sorte que l'interface entre les deux composés 14, 24 soit maîtrisée et exempte d'espaces vides (ou remplis d'air). Pour les mêmes raisons, il est avantageux que l'insert de connexion 24 comprenne un renflement au sein du support isolant 14, son diamètre central étant ainsi supérieur au diamètre des surfaces de connexion 26, 28, au niveau desquelles le matériau isolant forme un col, ou un goulot, 30 autour de l'insert : l'insert conducteur 24 est en quelque sorte enrobé, « noyé », dans le matériau isolant 14. La taille du support isolant 14, ainsi que l'épaisseur du goulot 30, dépend de la taille de l'insert conducteur 24, elle-même déterminée par le niveau du courant qui y circule, et des contraintes électromécaniques.

Les dispositifs de raccordement 12 d'une même barre 10 sont reliés entre eux par une tige 32 de forte conductivité électrique connectée, et de préférence unitaire, avec l'insert de connexion 24. La tige 32, en cuivre ou en aluminium, est dimensionnée en fonction du courant y transitant, et elle est avantageusement « rigide », c'est-à-dire non compressible ; cependant, pour assurer une certaine souplesse correspondant à une tolérance dans le positionnement relatif des dispositifs de raccordement 12 dans le sens de la connexion (orthogonal aux surfaces de raccordement 16 et de connexion 26), de préférence, la section de la tige 32 est « aplatie », de forme oblongue.

La tige de liaison conductrice 32 est elle aussi intégrée à ses extrémités 34 dans l'isolant 14 du dispositif de raccordement 12 ; sur le reste de sa longueur, la partie résiduelle 36 correspondant à la longueur apparente de la tige 32 est revêtue d'un isolant 38 qui assure une tenue diélectrique suffisante. Pour restreindre l'encombrement nécessaire autour de la barre 10, un blindage électrostatique 40 de la partie résiduelle 36 peut également être mis en place. De préférence, l'ensemble des composants isolants 14, 38 de la barre de connexion 10 est réalisé en une étape sur l'ensemble des éléments conducteurs 24, 32 ; de même, le blindage 20, 40 est de préférence unitaire.

Pour éviter les amorçages lors du raccordement électrique et assurer un contact étanche entre les dispositifs de raccordement 12, 12' superposés des deux barres 10, 10' tel qu'illustré en figure 1, le matériau isolant des supports 14 est déformable, et notamment son épaisseur peut être diminuée par écrasement orthogonal entre les deux faces opposées 16, 18 ; par exemple il s'agit d'un élastomère dont les qualités diélectriques sont connues et optimisées, notamment en ce qui concerne la compacité. En particulier, le support 14 est surmoulé par un polymère d'éthylène-propylène-diène ou EPDM (« *Ethylene-Propylene Diene Monomer rubber* »), ou par du silicone. Ainsi, en ce qui concerne une fabrication préférée d'une barre 10, le coeur conducteur (inserts + tige) 24, 32 est d'abord réalisé, en cuivre ou en aluminium, par les techniques existantes, par exemple en matrice ou par moulage. Cet ensemble est surmoulé avec un isolant 14, 38 de type élastomère EPDM ou silicone, avec avantageusement présence d'un agent d'adhérisation pour assurer une interface cohésive et sans défaut entre coeur conducteur et revêtement isolant. Le blindage 20, 40 peut être réalisé, par exemple sur une surface externe ébavurée, par une métallisation ou de préférence par un surmoulage avec un élastomère de même type mais chargé, ce qui permet de conserver les mêmes propriétés de déformation sur l'ensemble du dispositif de raccordement 12, entre corps isolant 14 et blindage 20.

La hauteur de l'insert conducteur 24, définie par la distance entre ses deux surfaces de connexion 26, 28, est donc inférieure à l'épaisseur du support isolant 14 au repos ; une compression orthogonale du support isolant 14 peut rapprocher les surfaces de raccordement 16, 18 du support 14 pour que leur écartement soit égal à ladite hauteur : en usage, les surfaces isolantes 16, 16' sont mises en contact, une déformation est assurée jusqu'à ce que les surfaces de connexion 26, 26' conductrices de l'insert 24 soient en contact l'une avec l'autre, et l'assemblage est maintenu dans cette position par des moyens de serrage tant que le raccordement électrique est souhaité.

Pour maintenir la déformation des deux supports isolants 14, 14' et donc le contact entre les surfaces de connexion 26, 26' des inserts 24, 24' juxtaposés, un serrage est réalisé. A cette fin, l'insert de connexion 24 est percé d'un orifice central 44 dans lequel peut se mettre en place un moyen de liaison, notamment de type boulon ou goujon 48. Il est préféré que l'orifice 44 tolère un certain jeu pour faciliter la mise en place et le raccordement, cette option permettant en outre un centrage et donc une optimisation du contact entre les deux supports isolants 14, 14' et leur blindage 20, 20'. Le moyen de liaison 48 inséré dans l'orifice 44 est maintenu grâce à un dispositif de serrage 50 à une de ses extrémités au moins. Avantageusement, le dispositif de serrage 50, outre l'assurance de la compression et le maintien en position serrée de l'assemblage, permet d'assurer l'isolation de la surface 18 du dispositif de raccordement 12 qui reste libre (opposée dans le cadre illustré à la surface 16 de connexion électrique).

Le dispositif de serrage 50 comprend en particulier une surface plane de taille au moins égale à la surface de raccordement 18 à laquelle il est destiné ; de préférence, il s'agit d'un couvercle isolant dont la forme est optimisée pour la tenue diélectrique. Il est préféré, pour assurer une étanchéité et une protection maximale contre les amorçages, que le matériau du dispositif de serrage et d'obturation 50 soit non déformable, par exemple un matériau thermodurcissable de type thermoplastique, époxy ou polyester, voire thermoplastique.

De préférence, pour assurer la déformation du support 14 du dispositif de raccordement 12 qu'il protège, et pour maintenir cet état, le dispositif d'obturation 50 est associé à une tige filetée coopérant avec l'orifice 44 de l'insert de connexion 24. Notamment, un insert rigide 52 muni d'un orifice taraudé 54 est mis en place au centre du couvercle 50, par exemple surmoulé de manière cohésive ; l'orifice 54 est adapté pour coopérer avec le goujon 48 (qui peut même y être monté imperdable) de serrage traversant l'orifice 44 de l'insert 24 : le même élément 48 permet ainsi le serrage du couvercle 50 sur le dispositif de raccordement 12. Comme il ne s'agit pas ici de réaliser la connexion électrique, l'insert 52 peut être de forme et/ou matériau quelconques ; il est de préférence métallique afin d'assurer un rôle de déflecteur diélectrique et une qualité d'ancrage optimale pour la solidité du serrage.

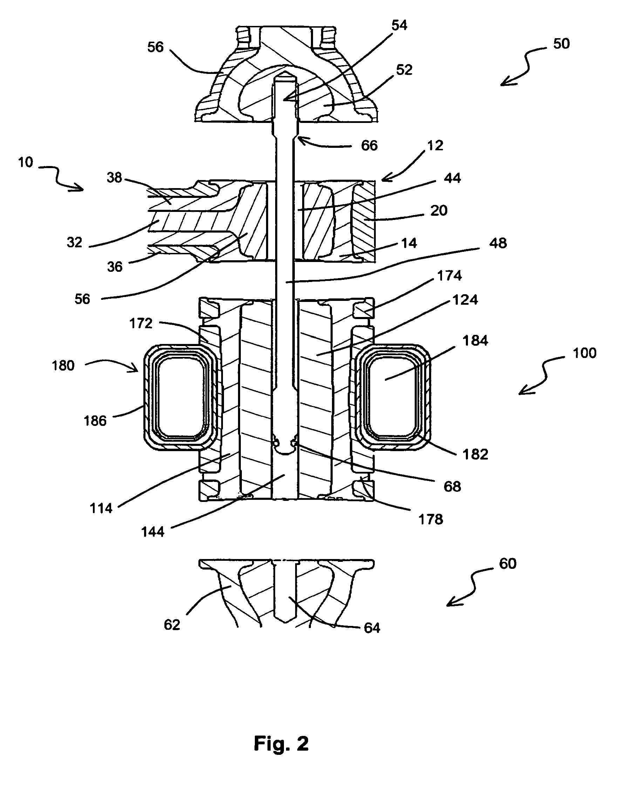

Selon une option, le couvercle 50 comprend des moyens de vissage, par exemple une excroissance à six pans susceptible de coopérer avec une clé permettant la rotation de l'ensemble couvercle 50 / goujon 48 pour assurer la compression des supports isolants 14 dispositifs de raccordement 12. Le matériau isolant du couvercle 50 peut par exemple être revêtu d'une métallisation de blindage électrostatique, de préférence agencé pour une continuité de blindage avec le dispositif de raccordement 12 ; il est possible également, tel que schématisé en figure 2, de revêtir le couvercle d'une coque 56 le protégeant des chocs, par exemple un revêtement surmoulé en élastomère.

Dans la majorité des cas, le dispositif de raccordement 12 d'une barre 10 est destiné à se connecter sur une borne d'un appareillage électrique. Pour la simplicité d'assemblage, il est préféré que les deux faces opposées 16, 18 des dispositifs de raccordement 12 des barres 10 soient identiques : il apparaît donc que la connexion sur une borne d'un appareillage électrique est réalisée également par contact et compression, c'est-à-dire de façon différente de l'art antérieur. Il est alors avantageux que le raccordement électrique à une borne d'une barre 10 se fasse également directement, par contact et compression, avec modification adaptée des bornes des appareillages électriques, et notamment « aplatissement » : la borne 60 comprend, de façon similaire au dispositif de raccordement 12, une surface de contact superposable à la surface 18 du support 14 du dispositif de raccordement 12 de la barre 10, et sur laquelle débouche un insert de connexion 62, de préférence muni d'un orifice taraudé 64 correspondant à l'orifice taraudé 54 du dispositif de serrage 50. La borne 60, de préférence blindée, est principalement composée d'un matériau isolant surmoulé sur l'insert 62, et présente avantageusement un creux déflecteur sous la surface de contact qui optimise les caractéristiques diélectriques ; comme pour le couvercle 50, le matériau est de préférence non déformable, de type thermodur ou thermoplastique.

De préférence, les moyens de serrage 48, 50, 60 ne sollicitent par directement les dispositifs de raccordement 12 des barres 10 : le goujon 48 est de diamètre inférieur au diamètre de l'orifice 44 des inserts 24, qui n'est pas fileté, ce qui permet d'offrir une tolérance de positionnement. Avantageusement, pour garantir la pression au cours du temps et pallier des déformations plastiques dues au fluage local de la matière, le goujon 48 n'est pas de diamètre constant : tel qu'illustré en figure 2, des réductions de diamètre 66 sont aménagées dans la tige 48 en fonction de sa longueur et des efforts axiaux à supporter ; de fait, la déformation élastique de la tige 48, et donc son allongement, peuvent ainsi être augmentées pour former une réserve de déformation élastique pour les compensations du fluage sur la durée de vie de l'assemblage.

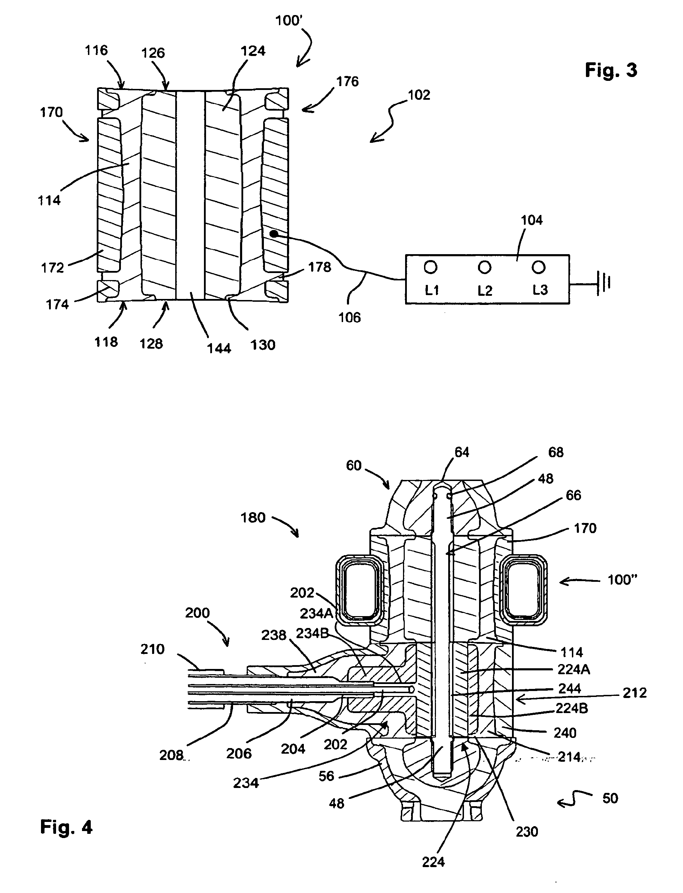

Avantageusement également, le serrage est optimisé par la présence d'un joint torique 68 à une extrémité de la tige 48 et coopérant avec l'orifice 64 dans lequel elle s'insère - en particulier dans la borne 60 lorsque la tige 48 est montée imperdable dans un dispositif d'obturation et serrage 50. La pression élastique exercée dans le taraudage récepteur 64 permet notamment un montage «à l'envers », avec blocage partiel du dispositif d'obturation 50 lorsqu'il est placé sous l'assemblage (voir par exemple figure 4).

Selon l'invention, le capteur 100, de tension et/ou de courant et/ou autre, est adapté à la configuration plane de l'assemblage précédent et, tel que schématisé en figure 2, il vient s'intercaler par exemple entre la borne 60 et le dispositif de raccordement 12 de la barre 10, la solidarisation entre les éléments étant achevée de la même façon que précédemment par un dispositif d'obturation 50 : seul le goujon 48 est modifié, en voyant sa longueur adaptée au nouvel assemblage.

En figure 3 est illustré un dispositif de mesure 102 adapté pour déterminer la tension dans la barre de façon capacitive. Le dispositif de mesure 102 comprend un circuit de traitement 104 de l'information détectée par un élément capteur 100 auquel le circuit de traitement 104 couplé à la masse est relié par un conducteur 106. En particulier, le circuit de traitement 104 peut comprendre une capacité afin de mesurer la tension de façon capacitive : l'élément capteur 100 forme alors la partie « haute tension » du diviseur capacitif formé avec la capacité et le circuit de traitement 104 permet l'évaluation de la grandeur électrique concernée.

L'élément capteur 100 est quant à lui modifié par rapport à l'art antérieur comme les dispositifs de raccordement 12 précédents, de façon à se présenter sous la forme d'un cylindre traversé par un insert conducteur percé enrobé dans un isolant ; par simplification, les signes de référence seront ainsi augmentés de 100 pour les éléments correspondants.

En particulier, le support 114 isolant du capteur 100 comprend deux surfaces opposées 116, 118, destinées au raccordement, qui sont sensiblement planes et parallèles l'une à l'autre, et avantageusement circulaires, parallèles et superposables. Le capteur 100 comprend en outre un insert de connexion 124 de forte conductivité électrique, usuellement en cuivre ou en aluminium, qui le traverse dans son épaisseur, entre deux surfaces de connexion 126, 128 planes et parallèles qui sont accessibles de chaque côté du support isolant 114. L'insert de connexion 124 est centré au sein du support isolant 114 et symétrique de révolution ; il est traversé entre ses deux surfaces de connexion 126, 128 par un orifice 144 permettant la mise en place des moyens de serrage, et notamment le passage d'une tige 48. De préférence, la tige 48 est montée sans jeu sur une partie au moins de sa longueur, par exemple sur la partie d'extrémité sans réduction de diamètre 66, afin de centrer le capteur 100 et d'optimiser la mesure.

Pour éviter les amorçages lors du raccordement électrique et assurer un contact étanche, le matériau isolant du support 114 est déformable, et notamment son épaisseur peut être diminuée par écrasement orthogonal entre les deux faces opposées 116, 118 ; notamment, il s'agit d'un élastomère dont les qualités diélectriques et la compacité sont connues et optimisées. En particulier, le support 114 est surmoulé par de l'EPDM ou par du silicone. La hauteur de l'insert conducteur 124, définie par la distance entre ses deux surfaces de connexion 126, 128, est donc inférieure à l'épaisseur du support isolant 114 au repos ; une compression orthogonale du support isolant 114 peut rapprocher les surfaces de raccordement 116, 118 du support 114 pour que leur écartement soit égal à ladite hauteur.

Pour optimiser.la tenue diélectrique, l'insert de connexion 124 est intégré au support isolant 114, et notamment le matériau isolant est surmoulé sur l'insert 124 de sorte que l'interface entre les deux composés 114, 124 soit maîtrisée et exempte d'espaces vides (ou remplis d'air). Pour les mêmes raisons, il est avantageux que l'insert de connexion 124 comprenne un renflement au sein du support isolant 114, son diamètre central étant ainsi supérieur au diamètre des surfaces de connexion 126, 128, au niveau desquelles le matériau isolant forme un col, ou un goulot, 130 autour de l'insert : l'insert conducteur 124 est en quelque sorte enrobé, « noyé », dans le matériau isolant 114.

Tout comme le dispositif de raccordement 12, le capteur 100 est revêtu, à l'exception des surfaces de raccordement 116, 118, d'une couche conductrice ou semi-conductrice 170 sur la surface externe de son support isolant 114 ; avantageusement, le revêtement conducteur 170 est réalisé par surmoulage du même élastomère que le support isolant 114 mais chargé, même si d'autres options sont possibles.

Dans un mode de réalisation illustré en figure 3, le revêtement conducteur 170 sert directement à obtenir une grandeur électrique caractéristique, à savoir la tension dans l'insert 124 ; il convient donc de dissocier la zone centrale 172 du revêtement 170 destinée à la prise de tension des parties d'extrémité 174 reliées électriquement au blindage 20 des dispositifs de raccordement 12, usuellement à la masse. A cette fin, des épargnes 176 sont creusées sur la circonférence du revêtement conducteur 170 jusqu'au support isolant 114 afin de délimiter trois parties distinctes du revêtement 170. De préférence, les épargnes 176 sont au moins partiellement comblées par de l'isolant pour éviter tout amorçage entre les différentes parties du revêtement 172, 174, et donc des distorsions de mesure, par exemple une mise en place d'éléments de protection comme des anneaux en EPDM ; selon le mode de réalisation illustré, le revêtement 170 est d'abord réalisé, puis les épargnes 176 sont formées et l'insert 124 est mis en place dans le revêtement 172, 174 pour surmouler l'isolant 114 dans l'espace résiduel, formant par la même occasion des éléments de protection 178 dans les épargnes 176. La partie centrale 172 est de géométrie déterminée ; elle est reliée au circuit de traitement 104 du dispositif de mesure 102 par les conducteurs 106 de sorte que la tension générée dans ladite partie 172 permet de déterminer la tension au sein du raccordement électrique.

Un tel capteur de tension capacitif 100' peut être associé à la mesure du courant également : un capteur mixte 100 est illustré en figure 2, dans une position d'assemblage. Le capteur 100 diffère du capteur capacitif 100' en ce que des moyens de mesure du courant 180 lui sont associés au niveau de la partie centrale 172 de son revêtement. Un bobinage secondaire 182 enroulé autour d'un noyau magnétique ou amagnétique 184 est mis en place autour de l'insert 124 surmoulé par l'isolant 114, et relié par les moyens adaptés à un dispositif de mesure ou de protection. Selon un mode de réalisation non illustré, le bobinage secondaire 182 est enrobé dans le revêtement conducteur 170 ; il est avantageux de rapporter le bobinage secondaire 182 sur un élément capteur 100, auquel cas le bobinage 182 et son noyau 184 sont enrobés préalablement dans un isolant, par exemple une coque thermoplastique 186, puis mis en place autour du revêtement 170 de l'élément 100 du raccordement électrique à interfaces planes, par exemple par encliquetage avec des protubérances radiales de maintien ou dans un aménagement du blindage 170.

Avantageusement, la géométrie des capteurs selon l'invention 100, 100' est symétrique (notamment, les épargnes 176 sont à distance égale de chacune des faces 116, 118), mais d'autres configurations sont possibles. Il est bien entendu possible de modifier le capteur 100, 100' de manière appropriée pour obtenir la grandeur électrique souhaitée : voir par exemple figure 4 pour un capteur de courant seul 100", dans lequel les épargnes 176 ne sont pas nécessaires, et qui comprend de préférence un revêtement conducteur 170 sur toute la périphérie du support isolant 114. D'autres modes de réalisation sur le même principe sont envisagés, par exemple un capteur de tension résistif (non illustré) dans lequel des résistances reliées par un conducteur à un circuit de mesure sont enrobées et forment les moyens d'obtention de la grandeur électrique, qui débouchent du revêtement 170 par le conducteur.

Tel qu'illustré en figure 2, le capteur 100 se met en place sur l'un des dispositifs de raccordement 12 d'une barre 10 et le raccordement est effectué de façon simple, comme le raccordement de deux barres 10, 10' décrit en relation avec la figure 1. Il est en outre possible de modifier une configuration existante, par exemple sur un assemblage en fonctionnement, et d'ajouter ou changer un capteur 100 de façon retardée : il suffit de retirer le dispositif d'obturation 50, de positionner le capteur 100, de modifier la longueur de la tige 48 du dispositif d'obturation 50, et de resserrer ce dernier sur l'assemblage : les caractéristiques d'étanchéité sont assurées de façon simple et évidente par simple vissage, de sorte que les contraintes diélectriques sont faciles à respecter.

Outre la mesure d'un paramètre électrique au niveau d'un raccordement à une borne 60, le capteur 100 selon l'invention peut être utilisé à tout autre endroit d'une distribution/alimentation électrique. Notamment, il est possible d'assurer le serrage du capteur 100 sur une barre 10, ou un ensemble de barres 10, 10' reliées en « Y », en té ou en croix, par deux dispositifs d'obturation 50 (non illustré), les deux dispositifs 50 ne pouvant différer entre eux que par le montage imperdable du goujon 48 dans l'un.

Il est possible également de raccorder de la même façon, à un capteur 100 selon l'invention, un câble électrique muni d'une interface de liaison adapté : figure 4 (ici encore, par souci de clarté, les signes de référence sont augmentés de 200). Sur sa plus grande longueur, et comme il est classique, le câble 200 comprend un conducteur filaire enrobé dans un isolant, qui peut notamment être tri-couche. Au niveau d'une extrémité au moins, le câble adapté 200 est dénudé pour le raccordement ; en particulier, l'isolation est étagée et le câble 200 comprend une première partie 202 dans laquelle le conducteur est nu, une deuxième partie 204 dans laquelle le conducteur est recouvert d'une partie de l'isolant, et une troisième partie 206 dans laquelle l'isolant est complet ; sur sa plus grande longueur, le conducteur filaire comprend une quatrième partie 208 qui peut en outre être blindée et/ou une cinquième partie 210 recouverte d'une gaine de protection.

Le dispositif de raccordement 212 du câble 200 quant à lui est similaire à celui d'une barre 10: un support isolant 214 en matériau compressible, notamment de l'EPDM ou du silicone, est surmoulé autour un insert conducteur 224 de façon à ce que l'interface entre les deux soit étanche, exempte d'espaces libres. L'épaisseur du support 214, définie entre ses deux faces de raccordement opposées et sensiblement parallèles est supérieure à la hauteur de l'insert conducteur, définie par la distance entre ses deux surfaces de connexion, au repos, et égale à cette dernière en position de serrage par compression orthogonale du support isolant 214. Avantageusement, pour optimiser le raccordement entre le conducteur filaire et le dispositif de raccordement 212, l'insert conducteur 224 est lui-même en deux parties, un coeur 224A central rigide comprenant les surfaces de connexion et percé d'un orifice 244 pour le passage des moyens de serrage 248, surmoulé par un élastomère conducteur 224B ; de préférence, le surmoulage conducteur 224B, de même nature que le support isolant 214 mais chargé, est distant des surfaces de connexion 214 de façon à ce que le matériau du support isolant 214 forme un goulot 230 à chaque extrémité pour ne laisser que le coeur conducteur 224A, qui peut être un cylindre de révolution à directrice droite.

Outre ses deux surfaces de connexion, l'insert conducteur 224 comprend une excroissance latérale 234 comparable à la connexion de la tige 32 au dispositif de raccordement 12 d'une barre 10 ; l'excroissance 234 est munie de moyens de raccordement d'une première partie 202 d'extrémité du conducteur, et notamment un sertissage peut assurer la liaison entre les deux éléments conducteurs. En particulier, l'excroissance comprend un coeur conducteur 234A, prolongement du coeur 224A cylindrique, dans lequel est sertie la première partie 202 de conducteur filaire nu ; le coeur de l'excroissance 234A est enrobé par le même élastomère conducteur ou semi-conducteur, de façon unitaire avec l'enrobage du coeur de l'insert 224A, pour former l'excroissance conductrice 234 qui enrobe également une portion de la deuxième partie 204 du conducteur, afin d'optimiser la tenue diélectrique. L'assemblage conducteur et câble est enfin surmoulé par le matériau isolant, de façon unitaire avec le support 214, pour obtenir un manchon 238 duquel dépasse le conducteur filaire enrobé au niveau de sa troisième partie 206 (non blindée).

Le dispositif de raccordement est recouvert d'un blindage 240, avantageusement un élastomère conducteur surmoulé sur l'élastomère isolant, qui peut également servir de déflecteur ; le revêtement de blindage 240 recouvre le manchon 238 pour se terminer au niveau de la quatrième partie blindée 208 du conducteur filaire, de sorte à assurer la continuité électrique.

Bien que représenté dans une configuration précise en figure 4, le câble 200 peut naturellement être utilisé sans capteur 100 selon l'invention. De façon générale, chacun des éléments de raccordement présentés (capteur 100, barre 10, borne 60, dispositif d'obturation 50, câble 200) peut être utilisé isolé ou en combinaison avec un ou plusieurs éléments, identiques ou différents, au niveau d'un même raccordement électrique plan : chacun des systèmes obtenus bénéficie d'une' assurance des fonctions principales de raccordement avec peu de pièces. En particulier, le contact et la liaison électrique sont réalisés par le retrait de l'insert conducteur 24, 124, 224 par rapport à l'élastomère 14, 114, 214 sur la surface assurant la déformation dudit élastomère avant la mise en contact électrique ; l'étanchéité des interfaces est gérée par la déformation élastique et l'adhérence du surmoulage en élastomère isolant qui garantit simultanément l'isolation diélectrique des coeurs conducteurs 24, 34, 124, 224, 234 ; le serrage est assuré par un simple vissage ; la maîtrise des contraintes diélectriques est assurée par une conception adaptée des différents composants et interfaces, notamment leur forme, nature et positionnement avec un enrobage 30, 130, 230 des conducteurs de connexion 24, 124, 224 dans l'isolant 14, 114, 214 et un éventuel blindage électrostatique 20, 40, 174, 240 qui contribue à la robustesse du système ; l'ajout de dispositifs de mesure de paramètres électriques est réalisé par simple superposition d'un capteur 100.

## Revendications

1. Capteur (100) d'une grandeur électrique comprenant :
- un support (114) en matériau isolant susceptible d'être déformé et délimité par deux surfaces de raccordement opposées (116, 118) sensiblement parallèles ;
- un insert de connexion conducteur (124) intégré dans le support isolant (114) et débouchant sur les deux surfaces de raccordement (116, 118) au niveau de deux surfaces de connexion (126, 128) planes parallèles, la hauteur de l'insert (124) entre ses deux surfaces de connexion (126, 128) étant inférieure à la distance entre les deux surfaces de raccordement (116, 118) lorsque le matériau isolant du support (114) est au repos, et supérieure ou égale à ladite distance lorsque le matériau est entièrement déformé par compression entre ses surfaces de raccordement (116, 118), l'insert (124) étant percé d'un orifice (144) débouchant dans ses deux surfaces de connexion (126, 128) ;
- une partie de revêtement conducteur (172) sur au moins une partie de la surface externe du support isolant (114) distante de chacune des surfaces de raccordement (116, 118) ;
- des moyens permettant l'obtention d'une grandeur électrique représentative du circuit électrique dans lequel se trouve l'insert de connexion (124) associés à ladite partie de revêtement conducteur (172) ;
- dans lequel les interfaces entre le support isolant (114), l'insert conducteur (124) et la partie de revêtement conducteur (172) sont étanches.

2. Capteur selon la revendication 1 dans lequel les deux surfaces opposées de raccordement (116, 118) et les deux surfaces de connexion (126, 128) sont sous forme de disques concentriques.

3. Capteur selon l'une des revendications 1 ou 2 dans lequel les deux surfaces opposées de raccordement (116, 118) et les deux surfaces de connexion (126, 128) sont superposables.

4. Capteur selon l'une des revendications 1 à 3 dans lequel le support isolant (114) forme un col (130) au niveau des extrémités (126, 128) de l'insert de connexion (124), de sorte que ledit insert (124) est enrobé dans le matériau isolant.

5. Capteur selon l'une des revendications 1 à 4 dans lequel le matériau isolant (114) est un élastomère surmoulé sur l'insert conducteur (124).

6. Capteur selon l'une des revendications 1 à 5 dans lequel les moyens d'obtention de la grandeur électrique comprennent un conducteur (106) associé à la partie de revêtement (172), le capteur (100') comprenant en outre des parties d'extrémité de blindage conducteur (174) sur la surface externe du support isolant (114) adjacente à chacune des surfaces de raccordement (116, 118), lesdites parties d'extrémité de blindage conducteur (174) étant séparées de la partie de revêtement conducteur (172) formant moyens d'obtention de la grandeur électrique par une épargne (176).

7. Capteur selon la revendication 6 dans lequel les épargnes (176) sont des gorges creusées dans un revêtement conducteur (170) de façon à former les parties d'extrémité (174) et la partie de revêtement (172) d'obtention.

8. Capteur selon la revendication 7 comprenant en outre un isolant (178) dans les épargnes (176).

9. Capteur selon l'une des revendications 5 à 8 dans lequel la partie de revêtement conducteur (172) et/ou les parties de blindage (174) sont des surmoulages de l'élastomère du support isolant (114), chargé pour être conducteur.

10. Capteur selon l'une des revendications 1 à 9 dans lequel les moyens d'obtention d'une grandeur électrique comprennent des moyens de mesure et un conducteur de raccordement (106), lesdits moyens et/ou le conducteur étant intégrés dans la partie de revêtement conducteur (172).

11. Capteur selon l'une des revendications 1 à 10 dans lequel les moyens d'obtention d'une grandeur électrique comprennent des moyens de mesure du courant (180) avec un bobinage secondaire (182) enroulé autour d'un noyau (184) disposé autour de la partie de revêtement conducteur (172).

12. Dispositif de mesure du courant comprenant un capteur selon la revendication 10 dans lequel les moyens de mesure sont aptes à mesurer le courant ou un capteur selon la revendication 11, et un circuit de traitement permettant de déterminer le courant circulant dans les moyens de mesure de l'intensité (180).

13. Dispositif de mesure de la tension comprenant un capteur selon l'une des revendications 1 à 11 ou un dispositif de mesure du courant selon la revendication 12, un conducteur (106) connecté à la partie de revêtement conducteur (172) pour former les moyens d'obtention de la tension, et des moyens (104) de détermination de la tension obtenue par le conducteur (106).

## Claims

1. A sensor (100) for measuring an electric quantity comprising:
- a support (114) made from insulating material able to be deformed and delineated by two substantially parallel opposite connection surfaces (116, 118);
- a conducting connection insert (124) integrated in the insulating support (114) and opening out on the two connection surfaces (116, 118) at the level of two parallel flat connection surfaces (126, 128), the height of the insert (124) between its two connection surfaces (126, 128) being smaller than the distance between the two connection surfaces (116, 118) when the insulating material of the support (114) is at rest, and greater than or equal to said distance when the material is completely deformed by compression between its connection surfaces (116, 118), a hole (144) opening out onto its two connection surfaces (126, 128) being drilled in the insert (124);
- a conducting coating part (172) over at least a part of the external surface of the insulating support (114) distant from each of the connection surfaces (116, 118);
- means for obtaining an electric quantity representative of the electric circuit in which the connection insert (124) associated with the conducting coating part (172) is located;
- wherein the interfaces between the insulating support (114), the conducting insert (124) and the conducting coating part (172) are tightly sealed.

2. The sensor according to claim 1 wherein the two opposite connection surfaces (116, 118) and the two connection surfaces (126, 128) are in the form of concentric disks.

3. The sensor according to one of claims 1 or 2 wherein the two opposite connection surfaces (116, 118) and the two connection surfaces (126, 128) are superposable.

4. The sensor according to one of claims 1 to 3 wherein the insulating support (114) forms a neck (130) at the level of the ends (126, 128) of the connection insert (124) so that said insert (124) is coated in the insulating material.

5. The sensor according to one of claims 1 to 4 wherein the insulating material (114) is an elastomer over-moulded on the conducting insert (124).

6. The sensor according to one of claims 1 to 5 wherein the means for obtaining the electric quantity comprise a conductor (106) associated with the coating part (172), the sensor (100') further comprising conducting shielding end parts (174) on the external surface of the insulating support (114) adjacent to each of the connection surfaces (116, 118), said conducting shielding end parts (174) being separated from the conducting coating part (172) forming the means for obtaining the electric quantity by a resist (176).

7. The sensor according to claim 6 wherein the resists (176) are grooves hollowed out in a conducting coating (170) so as to form the end parts (174) and the coating part (172) for obtaining.

8. The sensor according to claim 7 further comprising an insulator (178) in the resists (176).

9. The sensor according to one of claims 5 to 8 wherein the conducting coating part (172) and/or shielding parts (174) are over-mouldings of the elastomer of the insulating support (114), charged to be conductive.

10. The sensor according to one of claims 1 to 9 wherein the means for obtaining an electric quantity comprise measuring means and a connecting conductor (106), said means and/or the conductor being integrated in the conducting coating part (172).

11. The sensor according to one of claims 1 to 10 wherein the means for obtaining an electric quantity comprise current measuring means (180) with a secondary winding (182) wound around a core (184) arranged around the conducting coating part (172).

12. A current measuring device comprising a sensor according to claim 10 wherein the measuring means are able to measure the current or a sensor according to claim 11, and a processing circuit for determining the current flowing in the current intensity measuring means (180).

13. A voltage measuring device comprising a sensor according to one of claims 1 to 11 or a current measuring device according to claim 12, a conductor (106) connected to the conducting coating part (172) to form the means for obtaining the voltage, and means (104) for determining the voltage obtained by the conductor (106).

## Patentansprüche

1. Messwandler (100) zur Messung einer elektrischen Größe mit
- einem verformbaren Isolierstoffträger (114), der durch zwei einander gegenüber liegende und annähernd parallel zueinander verlaufende Anschlussflächen (116, 118) begrenzt ist,
- einem in den Isolierstoffträger (114) integrierten leitenden Verbindungseinsatz (124), der mit zwei ebenen, parallel zueinander verlaufenden Verbindungsflächen (126, 128) an die beiden Anschlussflächen (116, 118) angrenzt, wobei die Höhe des Einsatzes (124) zwischen den beiden Verbindungsflächen (126, 128) bei unbelastetem Isolierstoff des Trägers (114) kleiner ist als der Abstand zwischen den beiden Anschlussflächen (116, 118) und bei vollständig verformtem Material nach dem Zusammendrücken der beiden Anschlussflächen (116, 118) größer oder gleich dem genannten Abstand ist, und wobei eine Bohrung (144) in den Einsatz (124) eingebracht ist, die an dessen beiden Verbindungsflächen (126, 128) mündet,
- einem leitenden Umhüllungsabschnitt (172), der auf mindestens einem von den beiden Anschlussflächen (116, 118) entfernt angeordneten Teil der Außenfläche des Isolierstoffträgers (114) aufgebracht ist,
- dem genannten leitenden Umhüllungsabschnitt (172) zugeordneten Mitteln zur Erfassung einer elektrischen Größe, die den Stromkreis mit dem darin eingesetzten Verbindungseinsatz (124) abbildet,
- wobei die Übergangsflächen zwischen dem Isolierstoffträger (114), dem leitenden Einsatz (124) und dem leitenden Umhüllungsabschnitt (172) dicht aufeinander liegen.

2. Messwandler nach Anspruch 1, bei dem die beiden einander gegenüber liegenden Anschlussflächen (116, 118) und die beiden Verbindungsflächen (126, 128) als konzentrische Scheiben ausgebildet sind.

3. Messwandler nach einem der Ansprüche 1 oder 2, bei dem die beiden einander gegenüber liegenden Anschlussflächen (116, 118) und die beiden Verbindungsflächen aufeinander gelegt werden können.

4. Messwandler nach einem der Ansprüche 1 bis 3, bei dem der Isolierstoffträger (114) an den Enden (126, 128) des Verbindungseinsatzes (124) einen Bund (130) aufweist, derart dass der genannte Einsatz (124) vom Isolierstoff eingefasst ist.

5. Messwandler nach einem der Ansprüche 1 bis 4, bei dem der Isolierstoff (114) ein auf den leitenden Einsatz (124) aufgespritztes Elastomer ist.

6. Messwandler nach einem der Ansprüche 1 bis 5, bei dem die Mittel zur Erfassung der elektrischen Größe einen der Umhüllung (172) zugeordneten Leiter (106) umfassen und der Messwandler (100) darüber hinaus auf der Außenfläche des lsolierstoffträgers (114) angeordnete, an die Anschlussflächen (116, 118) angrenzende Endabschnitte mit einer leitenden Schirmung (174) umfasst, welche Endabschnitte mit der leitenden Schirmung (174) durch eine Ausnehmung (176) von dem als Mittel zur Erfassung der elektrischen Größe ausgebildeten leitenden Umhüllungsabschnitt (172) getrennt sind.

7. Messwandler nach Anspruch 6, bei dem die Ausnehmungen (176) als in eine leitende Umhüllung (170) eingebrachte Kehlen ausgebildet sind, derart dass so die Endabschnitte (174) und der zur Erfassung der Messgröße dienende Umhüllungsabschnitt (172) gebildet werden.

8. Messwandler nach Anspruch 7, der zusätzlich einen Isolierstoff (178) in den Ausnehmungen (176) umfasst.

9. Messwandler nach einem der Ansprüche 5 bis 8, bei dem der leitende Umhüllungsabschnitt (172) und/oder die Schirmungsabschnitte (174) als auf den Isolierstoffkörper (114) aufgespritzes und zur Herstellung der Leitfähigkeit mit Zusatzstoffen versetztes Elastomer ausgebildet sind.

10. Messwandler nach einem der Ansprüche 1 bis 9, bei dem die Mittel zur Erfassung einer elektrischen Größe Messmittel und einen Verbindungsleiter (106) umfassen, wobei die Messmittel und/oder der Verbindungsleiter in den leitenden Umhüllungsabschnitt (172) integriert sind.

11. Messwandler nach einem der Ansprüche 1 bis 10, bei dem die Mittel zur Erfassung einer elektrischen Größe Strommessmittel (180) mit einer Sekundärwicklung (182) umfassen, die auf einem um den leitenden Umhüllungsabschnitt (172) geführten Kern (184) aufgebracht ist.

12. Strommesseinrichtung mit einem Messwandler nach Anspruch 10, bei dem die Messmittel zur Strommessung ausgelegt sind, oder mit einem Messwandler nach Anspruch 11 sowie einer Verarbeitungsschaltung, mit deren Hilfe der über die Strommessmittel fließende Strom (180) gemessen werden kann.

13. Spannungsmesseinrichtung mit einem Messwandler nach einem der Ansprüche 1 bis 11 oder einer Strommesseinrichtung nach Anspruch 12, einem an den leitenden Umhüllungsabschnitt (172) angeschlossenen Leiter (106) zur Bildung der Spannungserfassungsmittel sowie Mitteln zur Bestimmung der über den Leiter (106) erfassten Spannung.
